(19) **Europäisches Patentamt**
**European Patent Office**
**Office européen des brevets**

(11) **EP 4 411 804 A1**

(12) **EUROPEAN PATENT APPLICATION**
published in accordance with Art. 153(4) EPC

(43) Date of publication:
**07.08.2024 Bulletin 2024/32**

(21) Application number: **22876285.2**

(22) Date of filing: **28.09.2022**

(51) International Patent Classification (IPC):
*H01L 23/12* (2006.01)        *H05K 1/14* (2006.01)

(52) Cooperative Patent Classification (CPC):
**H01L 23/12; H05K 1/14**

(86) International application number:
**PCT/JP2022/036055**

(87) International publication number:
**WO 2023/054419 (06.04.2023 Gazette 2023/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.09.2021   JP 2021161493**

(71) Applicant: **Kyocera Corporation
Kyoto-shi Kyoto 612-8501 (JP)**

(72) Inventor: **SUGIMOTO, Yoshimasa
Kyoto-shi, Kyoto 612-8501 (JP)**

(74) Representative: **Viering, Jentschura & Partner
mbB
Patent- und Rechtsanwälte
Am Brauhaus 8
01099 Dresden (DE)**

(54) **SUBSTRATE FOR MOUNTING SEMICONDUCTOR ELEMENT AND SEMICONDUCTOR DEVICE**

(57)     A semiconductor element mounting substrate includes a first substrate, a second substrate, a third substrate, a side surface conductor positioned on an inner surface of a groove and connected to a signal line, a first recess and a second recess positioned to extend from a third top surface of the third substrate to a first bottom surface of the first substrate and positioned side by side with the groove interposed therebetween, and a first side surface ground conductor and a second side surface ground conductor respectively positioned on inner surfaces of the first recess and the second recess. A width reduction portion is provided in which a spacing between the first recess and the second recess is smaller at the top of the width reduction portion than at the bottom of the width reduction portion.

FIG. 4

**Description**

TECHNICAL FIELD

The present disclosure relates to a semiconductor element mounting substrate and a semiconductor device.

BACKGROUND OF INVENTION

International Publication No. 2018/021209 discloses a semiconductor element mounting substrate and a semiconductor device. The semiconductor element mounting substrate includes a first substrate, a frame-shaped second substrate, and a frame-shaped third substrate. The first substrate has a top surface including a mounting region for mounting a semiconductor element and a peripheral region. The second substrate is positioned on the peripheral region of the first substrate. The third substrate is positioned on the second substrate.

SUMMARY

SOLUTION TO PROBLEM

In the present disclosure, a semiconductor element mounting substrate includes a first substrate, a frame-shaped second substrate, and a frame-shaped third substrate.
The first substrate has a first top surface including a mounting region allowing mounting of a semiconductor element and a peripheral region surrounding the mounting region.
The second substrate is positioned on the peripheral region of the first substrate and surrounds the mounting region.
The third substrate is positioned on the second substrate and surrounds the mounting region.
The first substrate, the second substrate, and the third substrate have a common outward facing first outer surface.
The semiconductor element mounting substrate further includes a groove, a signal line, a through conductor, a side surface conductor, a first cutout portion, a first recess, a second recess, a first side surface ground conductor, and a second side surface ground conductor.
The groove is positioned extending from the first top surface to a first bottom surface of the first substrate on the first outer surface.
The signal line is positioned on a second top surface of the second substrate. The through conductor is positioned inside the second substrate and is connected to the signal line.
The side surface conductor is positioned on an inner surface of the groove and electrically connected to the through conductor.
The first cutout portion is positioned on the first outer surface of the third substrate and overlaps the groove in planar perspective view.
The first recess and the second recess are positioned extending from a third top surface of the third substrate to the first bottom surface of the first substrate in the first outer surface and positioned side by side with the groove interposed therebetween.
The first side surface ground conductor and the second side surface ground conductor are respectively positioned on an inner surface of the first recess and an inner surface of the second recess.
A width reduction portion is provided between the first recess and the second recess, a spacing between the first recess and the second recess being smaller at a top of the width reduction portion than at a bottom of the width reduction portion.
In the present disclosure, a semiconductor device includes the above semiconductor element mounting substrate and a semiconductor element.
The semiconductor element is mounted on the mounting region and is electrically connected to the signal line.

BRIEF DESCRIPTION OF THE DRAWINGS

FIG. 1 is a perspective view illustrating a semiconductor device according to an embodiment of the present disclosure.
FIG. 2A is a perspective view in which a semiconductor element mounting substrate according to Embodiment 1 of the present disclosure is viewed from above.
FIG. 2B is a perspective view in which the semiconductor element mounting substrate according to Embodiment 1 of the present disclosure is viewed from below.

FIG. 2C is a perspective view in which the semiconductor element mounting substrate according to Embodiment 1 of the present disclosure is viewed from below with a main portion of a first substrate removed.

FIG. 3 is a sectional view taken along line A-A in FIG. 2A.

FIG. 4 is an enlarged view of part C1 of FIG. 2A.

FIG. 5 is an enlarged view of part C2 of FIG. 2C.

FIG. 6 is a diagram mainly illustrating signal conductors in part C2 of FIG. 2C.

FIG. 7 is a diagram mainly illustrating internal ground conductors in part C2 of FIG. 2C.

FIG. 8 is an enlarged perspective view illustrating the area around a first cutout portion.

FIG. 9 is a diagram illustrating part of a semiconductor element mounting substrate of Variation 1.

FIG. 10A is a perspective view in which a semiconductor element mounting substrate of Variation 2 is viewed from above.

FIG. 10B is a perspective view in which the semiconductor element mounting substrate of Variation 2 is viewed from below.

FIG. 10C is a sectional view taken along line A-A in FIG. 10A.

FIG. 11 is an exploded perspective view of a semiconductor device in FIG. 1.

DESCRIPTION OF EMBODIMENTS

Hereafter, embodiments of the present disclosure will be described in detail while referring to the drawings.

(Embodiment 1)

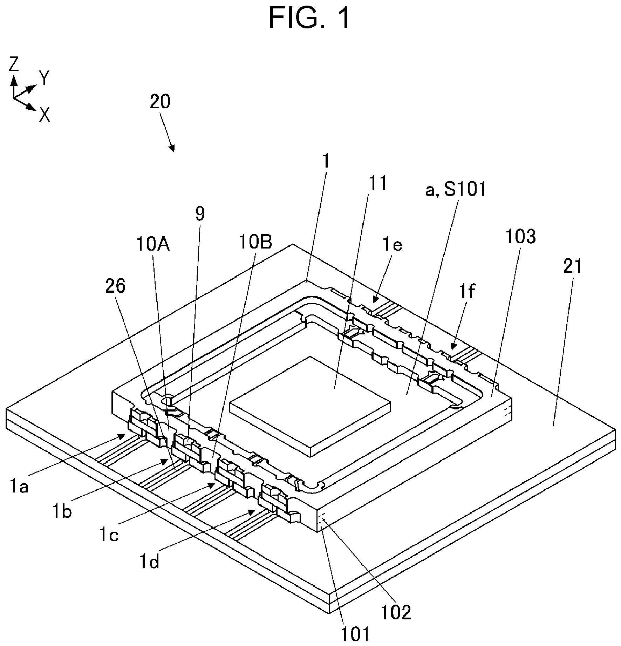

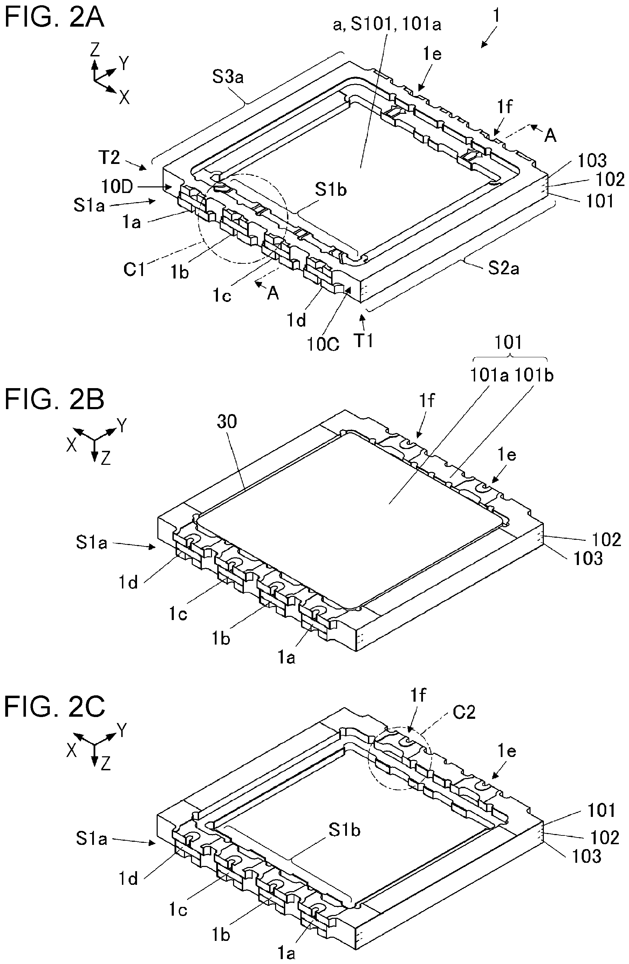

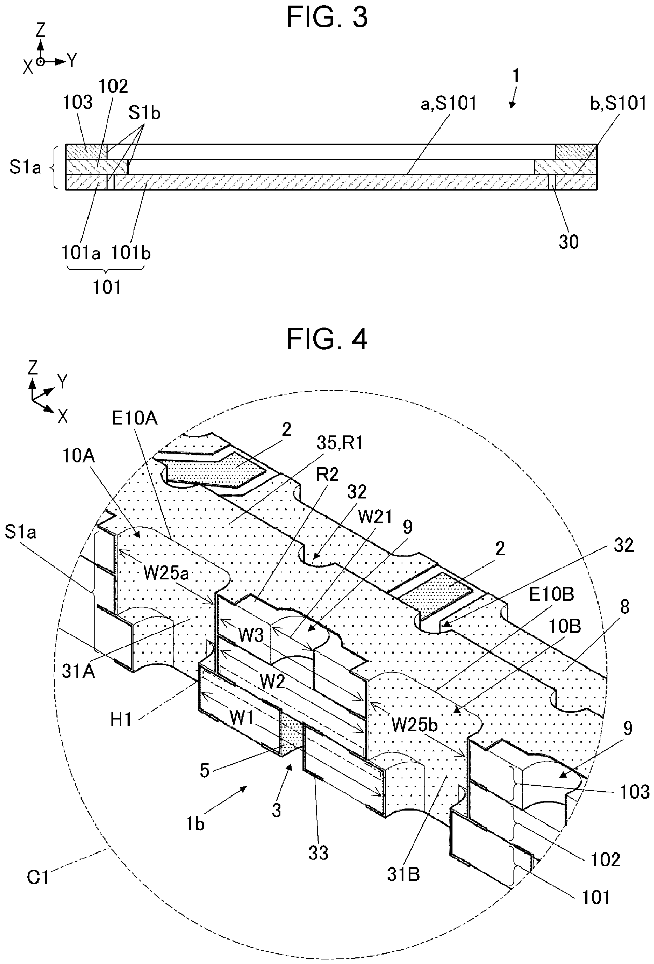

FIG. 1 is a perspective view illustrating a semiconductor device according to an embodiment of the present disclosure. FIGs. 2A to 2C illustrate a semiconductor element mounting substrate according to Embodiment 1 of the present disclosure. FIG. 2A is a perspective view in which a semiconductor element mounting substrate 1 according to Embodiment 1 is viewed from above. FIG. 2B is a perspective view in which the semiconductor element mounting substrate 1 is viewed from below. FIG. 2C is a perspective view in which the semiconductor element mounting substrate 1 is viewed from below with a main portion of a first substrate removed. FIG. 3 is a sectional view taken along line A-A in FIG. 2A. Hereafter, the directions of each part are represented with a direction from a first substrate 101 toward a third substrate 103 (Z direction) being an upward direction and direction parallel to a substrate surface of the first substrate 101 (X-Y plane direction) being a horizontal direction. These directions do not need to match the directions at the time of use of the semiconductor element mounting substrate 1 or a semiconductor device 20. In order to avoid confusion, in this specification, the top surface of the first substrate 101 is referred to as a first top surface S101 and the bottom surface of the first substrate 101 is referred to as a first bottom surface. Similarly, the top surface of a second substrate 102 is referred to as a second top surface, the bottom surface of the second substrate 102 is referred to as a second bottom surface, the top surface of the third substrate 103 is referred to as a third top surface and the bottom surface of the third substrate 103 is referred to as a third bottom surface.

The semiconductor device 20 and the semiconductor element mounting substrate 1 include the first substrate 101, the second substrate 102, and the third substrate 103. The first substrate 101 may have a single layer structure or a multilayer structure in which multiple insulating layers are stacked on top of one another. In the case of a multilayer structure, the first substrate 101 may include metal films positioned between the multiple insulating layers. This also applies to the second substrate 102 and the third substrate 103. A multilayer structure facilitates the design of signal wiring having a multilayer structure.

The first substrate 101 has the first top surface S101. The first top surface S101 includes a mounting region a that allows mounting of a semiconductor element 11 and a peripheral region b that surrounds the mounting region a. The first substrate 101 is composed of a ceramic such as an alumina ($Al_2O_3$) sintered material (alumina ceramic), for example.

The second substrate 102 is positioned on the peripheral region b of the first substrate 101. When viewed in plan view (when viewed in the Z direction), an outer edge of the second substrate 102 overlaps an outer edge of the first substrate 101 for the most part. The second substrate 102 has a frame-like shape surrounding the mounting region a. Similarly to the first substrate 101, the second substrate 102 is composed of a ceramic such as an alumina ($Al_2O_3$) sintered material (alumina ceramic), for example.

The third substrate 103 has a frame-like shape surrounding the mounting region a. The third substrate 103 is positioned on the second substrate 102. When viewed in plan view, an outer edge of the third substrate 103 overlaps the outer edge of the second substrate 102 for the most part. In plan view, an inner edge of the third substrate 103 may be positioned outward from an inner edge of the second substrate 102. The third substrate 103 is composed of the same material as the first substrate 101 and the second substrate 102, for example.

As illustrated in FIGs. 2A, 2B, and 3, the first substrate 101 includes a main portion 101a containing the mounting region a and a frame portion 101b containing the peripheral region b. A gap 30 may be positioned between the main portion 101a and the frame portion 101b. The first substrate 101 may be divided into the main portion 101a and the frame portion 101b, or part of the main portion 101a and part of the frame portion 101b may be connected to each other.

Temperature changes or temperature gradients occur inside the semiconductor element mounting substrate 1 during the process of manufacturing the semiconductor element mounting substrate 1 or the semiconductor device 20, or due to heat generated by the semiconductor element 11 when the semiconductor device 20 is operated. Stress may then occur due to thermal expansion and thermal contraction of the semiconductor element mounting substrate 1 or the semiconductor element 11. Even in such a case, the stress generated in the semiconductor element mounting substrate 1 can be relieved by the presence of the gap 30, and therefore the occurrence of damage and cracks in the semiconductor element mounting substrate 1 can be reduced. In addition, since deformation and warping of the mounting region a caused by deformation and warping of the semiconductor element mounting substrate 1 can be reduced, the semiconductor element 11 can be stably mounted in the mounting region a. In addition, damage to the semiconductor element 11 caused by deformation or warping of the mounting region a can be reduced.

When the first substrate 101 is divided into the main portion 101a and the frame portion 101b, the main portion 101a may be composed of a metal material. Iron, copper, nickel, chromium, cobalt, tungsten, molybdenum, or an alloy composed of these metals can be used as the metal material. The mounting region a may be electrically connected to a first ground conductor layer 7, which is described below, with a conductive bonding material such as solder or a brazing material. With this configuration, as well as heat dissipation of the semiconductor element mounting substrate 1 being improved, since the first ground conductor layer 7, second ground conductor layers 8, first side surface ground conductors 31A, and second side surface ground conductors 31B, which are described below, are connected to a ground layer 25 provided on an external mounting substrate described below via the mounting region a, the respective ground potentials are stabilized. In addition, the bonding area between the mounting region a, where the ground potential of semiconductor element mounting substrate 1 is applied, and the ground conductor provided on the external mounting substrate can be made larger, and consequently the ground potential of semiconductor element mounting substrate 1, including the mounting region a, is further stabilized. Therefore, the frequency characteristics in signal transmission portions of the semiconductor element mounting substrate 1 can be further improved.

The first substrate 101, the second substrate 102, and the third substrate 103 have a common first outer surface S1a, which faces outward, and a first inner surface S1b positioned on the opposite side from the first outer surface S1a. The first inner surface S1b faces the inside of the semiconductor element mounting substrate 1. As illustrated in FIG. 3, in the first substrate 101, the first inner surface S1b faces the gap 30. The first inner surface S1b in the second substrate 102 may extend inward to a greater extent than the first inner surface S1b of the first substrate 101 and the first inner surface S1b of the third substrate 103.

<Signal Transmission Parts>

The semiconductor element mounting substrate 1 includes a plurality of signal transmission parts 1a to 1f, for example. One signal transmission part 1b, which is positioned between the first outer surface S1a and the first inner surface S1b, is described below. The signal transmission part 1b has the same or substantially the same configuration as the other signal transmission parts 1a and 1c to 1f.

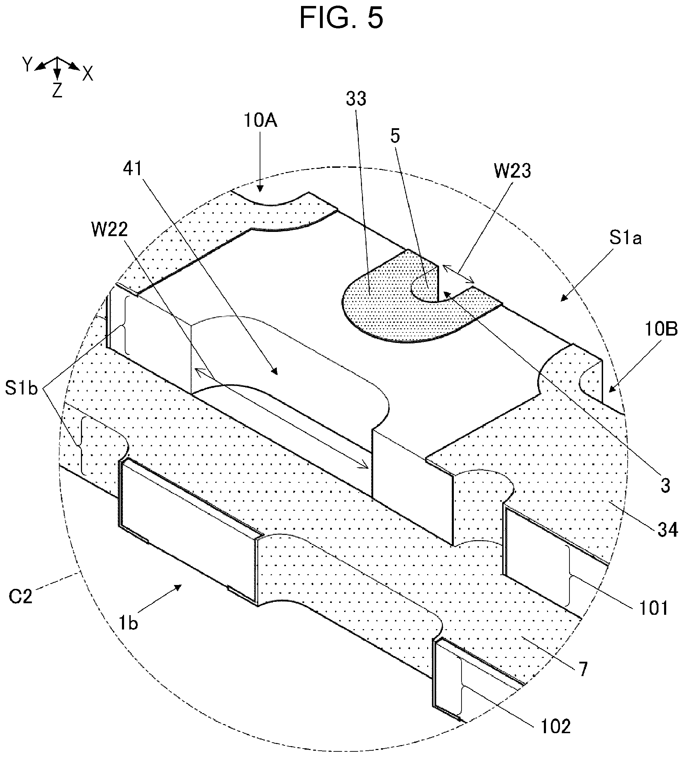

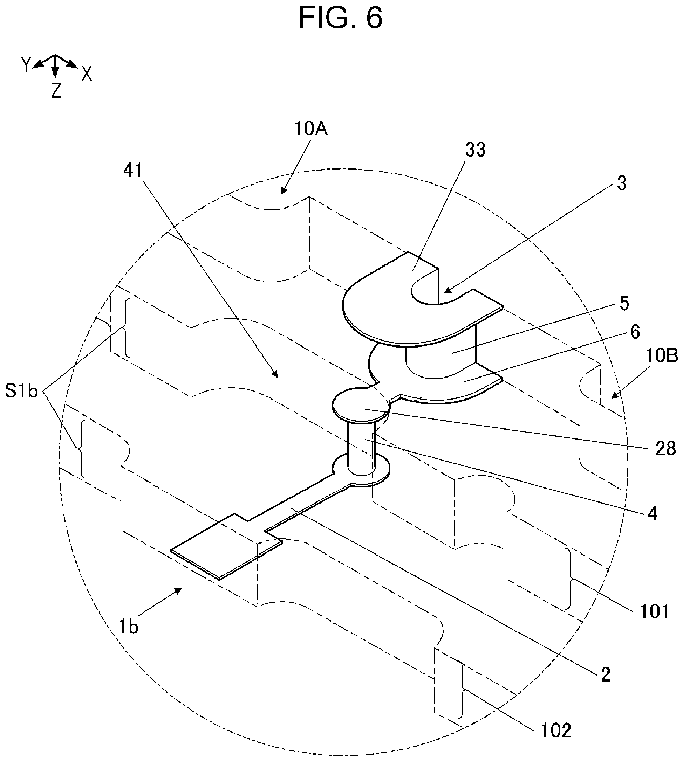

FIG. 4 is an enlarged view of part C1 of FIG. 2A. FIG. 5 is an enlarged view of part C2 of FIG. 2C. FIG. 6 is a diagram mainly illustrating signal conductors in part C2 of FIG. 2C. Although the signal transmission part 1f is illustrated in part C2 of FIG. 2C, FIGs. 5 to 7 illustrate the signal transmission part 1b as viewed from the first inner surface S1b. In FIGs. 4 and 5, conductor portions are indicated by shading.

The semiconductor element mounting substrate 1 includes a signal line 2, a groove 3, a through conductor 4, a side surface conductor 5, an electrode 6, a connection terminal 28, and a signal electrode 33 as constituent parts of the signal transmission part 1b.

The signal line 2 is positioned on the second top surface of the second substrate 102 and extends from one end, on the inner edge side, of the second substrate 102 to above the peripheral region b. The signal line 2 is composed of, for example, iron, copper, nickel, gold, chromium, cobalt, molybdenum, manganese, tungsten, or an alloy of these materials. The signal line 2 is connected to the semiconductor element 11.

The groove 3 is positioned in the first outer surface S1a of the first substrate 101 and extends from the first top surface S101 to the first bottom surface of the first substrate 101.

The side surface conductor 5 extends across the inner surface of the groove 3 and is electrically connected to the signal line 2, and the electrode 6 and the through conductor 4, which are described later, and conducts a radiofrequency signal therethrough. The side surface conductor 5 is composed of, for example, iron, copper, nickel, gold, chromium, cobalt, molybdenum, manganese, tungsten, or an alloy of these materials.

The groove 3 is positioned inward from the outer edge of the second substrate 102. Therefore, the second substrate 102 protrudes outward at the place where the groove 3 is located. With this configuration, the risk of the side surface conductor 5 formed in the groove 3 being damaged or short-circuited due to external influences is reduced, and the electrical conductivity of the side surface conductor 5 can be maintained in a good state. In planar perspective view, the outer edge of the second substrate 102 may be positioned outward from the outer edge of the first substrate 101. With this configuration, since the second substrate 102, which is located above the groove 3, protrudes outward, the risk of the side surface conductor 5 formed in the groove 3 being damaged or short-circuited due to external influences is further reduced, and the electrical conductivity of the side surface conductor 5 can be maintained in a good state.

The side surface conductor 5 inside the groove 3 is electrically connected to an external mounting substrate via a conductive bonding material such as solder. When this connection is being formed, a meniscus is formed at the lower edge of the inner surface of the groove 3 by the bonding material. As a result of this action, the side surface conductor 5 is electrically connected to the external mounting substrate in a stable manner. Therefore, the semiconductor element mounting substrate 1 can reduce fluctuations in the characteristic impedance in the signal transmission portions and improve the frequency characteristics.

The groove 3 includes a curved portion in planar perspective view. More specifically, the groove 3 may have a semi-circular shape (semi-circular, semi-elliptical, elongated semi-circular, etc.) for example, in planar perspective view. Temperature changes or temperature gradients occur inside the semiconductor element mounting substrate 1 during the process of manufacturing the semiconductor element mounting substrate 1 or the semiconductor device 20, or due to heat generated by the semiconductor element 11 when the semiconductor device 20 is operated. Stress may then occur due to thermal expansion and thermal contraction of the semiconductor element mounting substrate 1. In this case, the concentration of stress in the vicinity of the groove 3 can be reduced as a result of the groove 3 including the curved portion, and the occurrence of damage or cracks in the first substrate 101, the side surface conductor 5, the electrode 6, the signal electrode 33 on the first bottom surface, the first side surface ground conductor 31A and the second side surface ground conductor 31B can be reduced.

The through conductor 4 (FIG. 6) is electrically connected to the signal line 2 and is positioned so as to extend from the second top surface to the second bottom surface of the second substrate 102. The through conductor 4 is further electrically connected to the side surface conductor 5 via the electrode 6 provided around the upper end of the groove 3 on the first top surface of the first substrate 101. The through conductor 4 is at a position that overlaps the other end of the signal line 2 and is electrically connected to the other end of the signal line 2. In this case, a radio-frequency electrical signal can be more reliably transmitted from the through conductor 4 to the signal line 2, and transmission loss and reflection loss of the transmitted radio-frequency electrical signal can be reduced.

The electrode 6 (FIG. 6) is positioned on the first top surface of the first substrate 101 or the second bottom surface of the second substrate 102, between the first substrate 101 and the second substrate 102, and is electrically connected to the side surface conductor 5. The electrode 6 is a signal conductor layer positioned inside semiconductor element mounting substrate 1. More specifically, the electrode 6 may be provided around the upper end of the groove 3 (the end on the second substrate 102 side) in a direction (X-Y direction) perpendicular to the direction in which the side surface conductor 5 extends on the first top surface of the first substrate 101 or the second bottom surface of the second substrate 102, and electrically connected to the side surface conductor 5. Furthermore, in planar perspective view, the outer edge of the electrode 6 may be positioned further toward the inside of the semiconductor element mounting substrate 1 than the outer edge of the side surface conductor 5. In other words, the electrode 6 may configured so as to not be positioned on the exposed part of the second bottom surface of the second substrate 102 above the groove 3, i.e., so as to not be exposed on the second bottom surface of the second substrate 102. With this configuration, when the semiconductor device 20 is electrically connected to the mounting substrate via a conductive bonding material such as solder, wet spreading of the bonding material onto the electrode 6 via the side surface conductor 5 can be reduced. As a result, stress caused by a difference in thermal expansion coefficient between the second substrate 102 and the bonding material can be reduced. The possibility the characteristic impedance fluctuating in an unstable manner due to the wet spreading of the bonding material can also be reduced. As a result, the frequency characteristics in the side surface conductor 5 and the electrode 6, which are signal transmission portions, can be maintained even better.

The electrode 6 has a semi-circular (semi-circular, semi-elliptical, elongated semi-circular, etc.) outline (outline on side near mounting region a) in planar perspective view. This configuration allows the electrode 6 to be easily formed in the process of manufacturing the semiconductor element mounting substrate 1, and also reduces the possibility of stress being locally generated in the outline part of the electrode 6. Furthermore, the semiconductor element mounting substrate 1 can reduce unbalanced spreading of the electric field distribution in the vicinity of the outline of the electrode 6. Therefore, the semiconductor element mounting substrate 1 can reduce the risk of the electrode 6 peeling off or cracks appearing in the first substrate 101 or the second substrate 102 due to stress generated in the outline part of the electrode 6, and can further improve the frequency characteristics of the signal transmission portions.

The connection terminal 28 (FIG. 6) protrudes from the electrode 6 in the direction away from the groove 3 and is positioned on the first top surface of the first substrate 101 or the second bottom surface of the second substrate 102. The connection terminal 28 is an inner layer connection terminal, and the through conductor 4 is connected to a surface of the connection terminal on the second substrate 102 side. Via this connection, the electrode 6 is electrically connected to the signal line 2 via the connection terminal 28 and the through conductor 4. An increase in capacitances generated between the electrode 6 and the connection conductor 28 and the first ground conductor layer 7 (described below) and a reduction in the characteristic impedance of the signal transmission portions due to the electrode 6 and the connection conductor 28 can be suppressed by the connection terminal 28. Therefore, the characteristic impedance of the signal transmission portions is easy to set to a desired value, and the semiconductor element mounting substrate 1 can be reduced in size. In addition, the frequency characteristics in the signal transmission portions can be further improved.

The connection terminal 28 may be positioned in a straight line from the center of the outer edge of the electrode 6 (the outer peripheral edge of the second substrate 102) in planar perspective view in the opposite direction from the groove 3. With this configuration, the semiconductor element mounting substrate 1 enables the length of the signal transmission portion consisting of the electrode 6 and the connection terminal 28 to be shortened, and enables further improvement of the frequency characteristics in the signal transmission portion.

The signal electrode 33 (FIG. 6) is a film conductor that extends around the groove 3 so as to surround the groove 3 on the first bottom surface of the first substrate 101. The signal electrode 33 is connected to the side surface conductor 5 inside the groove 3. The signal electrode 33 has a semi-circular (semi-circular, semi-elliptical, elongated semi-circular, etc.) outline (outline on side near mounting region a) when viewed in plan view. This configuration allows the signal electrode 33 to be easily formed in the process of manufacturing the semiconductor element mounting substrate 1, and also reduces the possibility of stress being locally generated in the outer edge part of the signal electrode 33. Furthermore, when mounting the semiconductor device 20 on an external mounting substrate via the signal electrode 33 using a conductive bonding material such as solder, the occurrence of a situation in which stress generated around the signal electrode 33 and the bonding material becomes concentrated in a single place can be reduced. Therefore, the semiconductor element mounting substrate 1 can reduce the risk of the signal electrode 33 peeling off or cracks occurring in the first substrate 101 due to stress generated in the above-mentioned outline part of the electrode 6. Furthermore, with the above configuration of the signal electrode 33, the semiconductor element mounting substrate 1 is able to reduce the unbalanced spreading of the electric field distribution in the vicinity of the outline of the signal electrode 33. In addition, the signal electrode 33 can stabilize the electrical connection between the semiconductor element 11 and the external mounting substrate. Therefore, the frequency characteristics of the signal transmission portion including the signal electrode 33 can be improved.

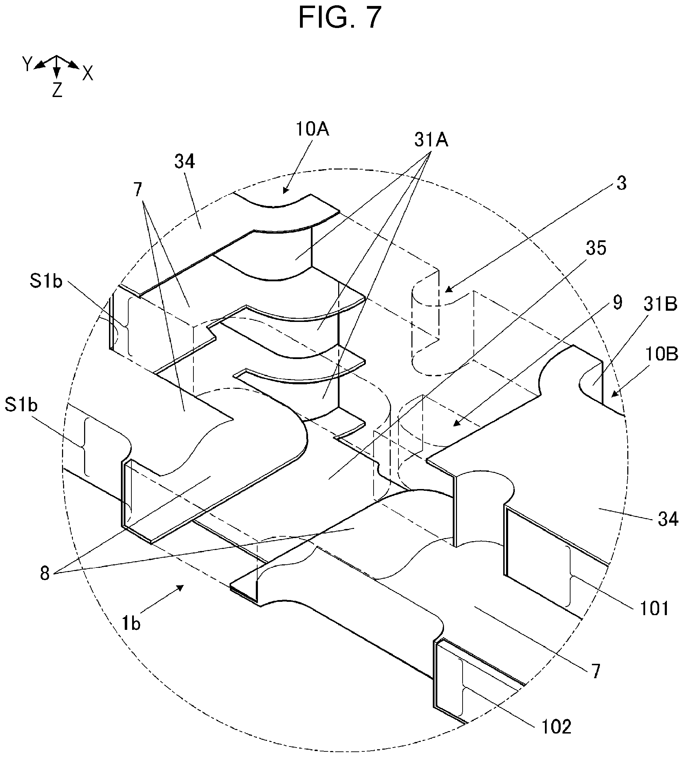

FIG. 7 is a diagram mainly illustrating internal ground conductors in part C2 of FIG. 2C. In FIG. 7, the first ground conductor layer 7 is represented with the center portion thereof cut away.

The semiconductor element mounting substrate 1 further includes the first ground conductor layer 7, the second ground conductor layers 8, metal layers 34 and 35, a first recess 10A, a second recess 10B, the first side surface ground conductor 31A, and the second side surface ground conductor 31B as constituent parts of the signal transmission part 1b.

The first ground conductor layer 7, the second ground conductor layers 8, and the metal layers 34 and 35 may be configured to be integrated with each other in each of the plurality of signal transmission parts 1a to 1f.

The first ground conductor layer 7 is positioned on the first top surface of the first substrate 101 or the second bottom surface of the second substrate 102, between the first substrate 101 and the second substrate 102, so as to be spaced apart from the electrode 6. The first ground conductor layer 7 is a ground conductor layer positioned inside the semiconductor element mounting substrate 1. The first ground conductor layer 7 may be positioned so as to surround the electrode 6 inside the semiconductor element mounting substrate 1, and this configuration can reduce the characteristic impedance in the side surface conductor 5 and the electrode 6. Furthermore, the possibility of the electric field generated in the signal transmission portions from the side surface conductor 5 to the through conductor 4 spreading into unintended areas via the electrode 6 can be reduced, and the electric field can couple the electrode 6 and the first ground conductor layer 7 to each other. Therefore, spreading of the electric field distribution of the signal transmission portions can be reduced. In addition, a radio-frequency electrical signal can be transmitted with electric field coupling between the electrode 6 and the first ground conductor layer 7. In addition, the characteristic impedance in the above signal transmission portions can be stabilized.

The second ground conductor layers 8 are positioned on the second top surface of the second substrate 102 so that the signal line 2 is interposed therebetween. This configuration allows a so-called coplanar line configuration to be formed in which the signal transmission portion is interposed between ground potential parts on the second top surface of the second substrate 102. Therefore, the frequency characteristics in the signal transmission portion including the signal line 2 can be further improved. The first ground conductor layer 7 may be positioned at a location overlapping the signal line 2 and the second ground conductor layers 8 when viewed in perspective view in the Z direction. With this configuration, the signal transmission portion including the signal line 2 is configured as a so-called coplanar line with a ground, and the frequency characteristics in the signal transmission portion can be further improved. The second ground conductor layers 8 may be partially positioned between the second substrate 102 and the third substrate 103.

The metal layers 34 are connected to the first side surface ground conductor 31A and the second side surface ground conductor 31B and extend on the first bottom surface of the first substrate 101. The metal layers 34 are positioned on the first bottom surface of the first substrate 101 so that the signal line 2 is interposed therebetween in planar perspective view. The presence of the metal layers 34 on the first bottom surface makes forming an electrical connection with the mounting substrate easier. In addition, dissipation of heat of semiconductor element mounting substrate 1 is improved through the metal layers 34.

The metal layer 35 is connected to the first side surface ground conductor 31A and the second side surface ground conductor 31B and extends on the third top surface of the third substrate 103. The presence of the metal layer 35 allows the electric field generated when a radio-frequency electrical signal is transmitted through the signal line 2 to couple to the metal layer 35 on the third top surface, and thus the spreading of an unwanted and unstable electric field distribution around the signal line 2 can be reduced. Therefore, the frequency characteristics in the signal transmission portions of the semiconductor element mounting substrate 1 can be further improved.

The first recess 10A and the second recess 10B are positioned to extend from the third top surface of the third substrate 103 to the first bottom surface of the first substrate 101 on the first outer surface S1a. Viewed in the Y direction (direction perpendicular to the first outer surface S1a), the first recess 10A and the second recess 10B are positioned side by side with the groove 3 interposed therebetween. The first recess 10A and the second recess 10B are positioned so as to be spaced apart from the groove 3 on both sides of the groove 3.

The first side surface ground conductor 31A is positioned on the inner surface of the first recess 10A. The second side surface ground conductor 31B is positioned on the inner surface of the second recess 10B. With this configuration, the first side surface ground conductor 31A and the second side surface ground conductor 31B are positioned so that the side surface conductor 5 through which a radio-frequency signal is conducted is interposed therebetween, and therefore the signal transmission portion is interposed between ground potential parts on the first outer surface S1a as well, and unwanted and unstable spreading of the electric field distribution and fluctuations in the characteristic impedance in the signal transmission portion of semiconductor element mounting substrate 1 can be reduced. Therefore, the frequency characteristics of the semiconductor element mounting substrate 1 can be further improved.

The first side surface ground conductor 31A may be continuous across the first substrate 101, the second substrate 102, and the third substrate 103. Furthermore, the first side surface ground conductor 31A may be positioned so as to extend across the entire inner surface of the first recess 10A. The second side surface ground conductor 31B may be continuous across the first substrate 101, the second substrate 102, and the third substrate 103. Furthermore, the second side surface ground conductor 31BA may be positioned so as to extend across the entire inner surface of the second recess 10B. This configuration allows the areas of the first side surface ground conductor 31A and the second side surface ground conductor 31B to be increased. Therefore, the ground potential of the semiconductor element mounting substrate 1 can be stabilized, and unnecessary and unstable spreading of the electric field distribution and fluctuations in the characteristic impedance around the side surface conductor 5 can be more stably reduced.

The portion of the first side surface ground conductor 31A located on the first substrate 101, the portion of the first side surface ground conductor 31A located on the second substrate 102, and the portion of the first side surface ground conductor 31A located on the third substrate 103 may overlap each other, at least to some extent, when viewed in planar perspective view. With this configuration, the semiconductor element mounting substrate 1 can further reduce unnecessary and unstable spreading of the electric field distribution and fluctuations in the characteristic impedance that occur in the signal transmission portions of the semiconductor element mounting substrate 1. This also applies to the second side surface ground conductor 31B.

The semiconductor element mounting substrate 1 further includes a first cutout portion 9, a second cutout portion 41, and inner surface grooves 32 as constituent parts of the signal transmission part 1b.

The first cutout portion 9 (FIG. 4) is positioned on the first outer surface S1a of the third substrate 103 and overlaps the groove 3 in planar perspective view. The first cutout portion 9 has a concave shape and may be positioned so as to extend from the third top surface to the third bottom surface of the third substrate 103. No ground conductor is positioned on the inner surface of the first cutout portion 9. When the semiconductor element mounting substrate 1 is reduced in size, the distances between the signal line 2 and the surrounding ground conductors become smaller, and this increases the capacitances between the signal transmission portions and the ground potential parts, and characteristic impedance may be reduced. However, the first cutout portion 9 is able to reduce the above capacitances and suppress the reduction in the characteristic impedance.

The first cutout portion 9 may have a larger outer shape than the groove 3 in plan view. With this configuration, the semiconductor element mounting substrate 1 can reduce the concentration of stress in the second substrate 102 positioned between the groove 3 and the first cutout portion 9. Therefore, the possibility of cracks or splits occurring in the second substrate 102 can be reduced.

A width W21 (FIG. 4) of the first cutout portion 9 in the X-direction (direction along the outer edge of the third top surface of the third substrate 103) may be smaller than a width W25a (FIG. 4), in the X-direction, of the first recess 10A located in the third substrate 103, or a width W25b (FIG. 4), in the X-direction, of the second recess 10B located in the third substrate 103. The X direction may be defined as a horizontal direction (first direction) along the first outer surface S1a. If the distance between the first recess 10A and the first cutout portion 9 and between the second recess 10B and the first cutout portion 9 is too small, the outwardly protruding portions of the third substrate 103 will be small and easily damaged. Therefore, the strength of the third substrate 103 is easily retained by reducing the width W21 of the first cutout portion 9 and securing the outwardly protruding portions.

The second cutout portion 41 (FIG. 5) is positioned on the first inner surface S1b of the first substrate 101. The second cutout portion 41 may overlap the groove 3 when viewed in perspective view in the Y direction (direction perpendicular to the first outer surface S1a). The second cutout portion 41 has a concave shape and may be positioned so as to extend from the first top surface to the first bottom surface of the first substrate 101. No ground conductor is positioned on the inner surface of the second cutout portion 41. The thickness of the ceramic (dielectric) of the first substrate 101 located in the Y direction of the groove 3 is reduced by the second cutout portion 41. Thus, the effective dielectric constant around the side surface conductor 5 in the groove 3 is reduced. Therefore, the characteristic impedance of the signal transmission portion is easily set to a desired value by adjusting the thickness (thickness in the Y direction) of the second cutout portion 41, and the frequency characteristics of the signal transmission portion can be further improved, for example, by reducing the reflection characteristics in a low frequency band.

A width W22 (FIG. 5) of the second cutout portion 41 in the X direction (direction along the outer edge of the third top surface of the third substrate 103) may be larger than a width W23 (FIG. 5) of the groove 3 in the X direction. With this configuration, a reduction in impedance can be more easily suppressed by making the width W22 of the second cutout portion 41 larger than the width of the side surface conductor 5 (corresponding to the width W23) along which a radio-frequency signal is transmitted.

Furthermore, the width W22 (FIG. 5) of the second cutout portion 41 in the X direction may be larger than the width W21 (FIG. 4) of the first cutout portion 9 in the X direction.

The inner surface grooves 32 are positioned on the first inner surface S1b of the third substrate 103 and the signal line 2 is interposed therebetween in the X direction (direction along the outer edge of the third top surface of the third substrate 103) when viewed in plan view. The inner surface grooves 32 are positioned so as to extend from the third top surface to the third bottom surface of the third substrate 103. Inner surface ground conductors, which are at the ground potential, are positioned on the inner surfaces of the inner surface grooves 32. The inner surface grooves 32, where the inner surface ground conductors are positioned, can reduce unnecessary and unstable spreading of the electric field distribution at the end of the signal line 2 on the side where the mounting region a is located, and can reduce fluctuations in the characteristic impedance of the signal transmission part 1b.

<Spacing Between First Recess and Second Recess>

The groove 3 is positioned between the first recess 10A and the second recess 10B on the first outer surface S1a. A width reduction portion H1 (FIG. 4) is provided between the first recess 10A and the second recess 10B. The spacing between the first recess 10A and the second recess 10B is smaller at the top of the width reduction portion H1 (positive direction of the Z axis) than at the bottom of the width reduction portion H1 (negative direction of the Z axis).

The width reduction portion H1 may be positioned within a height range that includes the upper end of the groove 3, or in a height range extending higher than the groove 3. In the width reduction portion H1, the spacing between the first recess 10A and the second recess 10B may become smaller in a stepwise or gradual manner. The width reduction portion H1 allows the spacing between the first recess 10A and the second recess 10B at the top of the width reduction portion H1 to be smaller than the spacing would be without the presence of the width reduction portion H1. Therefore, the spacing between the first side surface ground conductor 31A and the second side surface ground conductor 31B can be made smaller at the top of the width reduction portion H1. Making this spacing smaller increases the cutoff frequency of radio-frequency signals transmitted through the side surface conductor 5 inside the groove 3, the electrode 6, the through conductor 4, and the signal line 2, and broadens the bandwidth of the frequency characteristics of the signal transmission part 1b. Furthermore, the presence of the width reduction portion H1 enables the spacing between the groove 3 and the first recess 10A and the spacing between the groove 3 and the second recess 10B on the first bottom surface of the first substrate 101 to be increased. When the semiconductor element mounting substrate 1 is mounted on a mounting substrate, the signal electrode 33 and the metal layers 34 of the semiconductor element mounting substrate 1 are bonded to a signal electrode and ground electrodes of the mounting substrate via a conductive bonding material such as solder. Therefore, the risk of the signal electrode 33 and the metal layers 34 being short circuited by the conductive bonding material spreading on the first bottom surface of the first substrate 101 during the bonding process can be reduced by increasing the spacing between the groove 3 and the first recess 10A and the spacing between the groove 3 and the second recess 10B. Therefore, the reliability of semiconductor element mounting substrate 1 in terms of mounting can be improved.

A spacing W1 between the first recess 10A and the second recess 10B in the first substrate 101, a spacing W2 between the first recess 10A and the second recess 10B in the second substrate 102, and a spacing W3 between the first recess 10A and the second recess 10B in the third substrate 103 may be set to satisfy the following conditions

(1) and (2).

$$W1 \geq W2, W2 \geq W3...(1)$$

At least one of the values of W1, W2, and W3 is different ...(2)

With this configuration, the spacing between the first recess 10A and the second recess 10B is smaller at the top between the first substrate 101 and the second substrate 102, or between the second substrate 102 and the third substrate 103. As a result of the spacing between the first side surface ground conductor 31A and the second side surface ground conductor 31B being smaller at the top, the cutoff frequency of radio-frequency signals transmitted through the side surface conductor 5 in the groove 3, the electrode 6, the through conductor 4, and the signal line 2 is increased and the bandwidth of the frequency characteristics of signal transmission part 1b is broadened. Furthermore, since the spacing between the groove 3 and the first recess 10A and the spacing between the groove 3 and the second recess 10B can be increased while achieving a wider bandwidth, the reliability of the semiconductor element mounting substrate 1 in terms of mounting can be improved.

Furthermore, the spacings W1 to W3 may satisfy the following condition (3).

$$W1 > W2...(3)$$

With this configuration, the spacing between the first recess 10A and the second recess 10B, i.e., the spacing between the first side surface ground conductor 31A and the second side surface ground conductor 31B, can be made smaller at the height where the through conductor 4 is located, and the bandwidth of the frequency characteristics of the signal transmission part 1b can be broadened.

Furthermore, the spacings W1 to W3 may satisfy the following condition (4).

$$W2 = W3...(4)$$

With this configuration, the first recess 10A and second recess 10B located in the second substrate 102 and the first recess 10A and second recess 10B located in the third substrate 103 can include many overlapping regions in plan view. In the overlapped regions, the first side surface ground conductor 31A and the second side surface ground conductor 31B located on the second substrate 102 and the first side surface ground conductor 31A and the second side surface ground conductor 31B located on the third substrate 103 are continuous with each other. Therefore, the shapes of the first side surface ground conductor 31A and the second side surface ground conductor 31B can be stabilized and the ground potential of the signal transmission part 1b can be stabilized. Thus, the frequency characteristics of the signal transmission part 1b can be stabilized.

If the spacing W2 is made too small, the bandwidth of the frequency characteristics is broadened and the reflection characteristics in a low-frequency band are degraded due to the decrease in the characteristic impedance. However, the characteristic impedance around the side surface conductor 5 is increased by the second cutout portion 41, and as a result, the degradation of the reflection characteristics can be reduced.

The thickness (maximum dimension in Y direction) of the first recess 10A may be uniform from the first substrate 101 to the third substrate 103. The thickness (maximum dimension in Y direction) of the second recess 10B may be uniform from the first substrate 101 to the third substrate 103.

<Third Top Surface of Third Substrate>

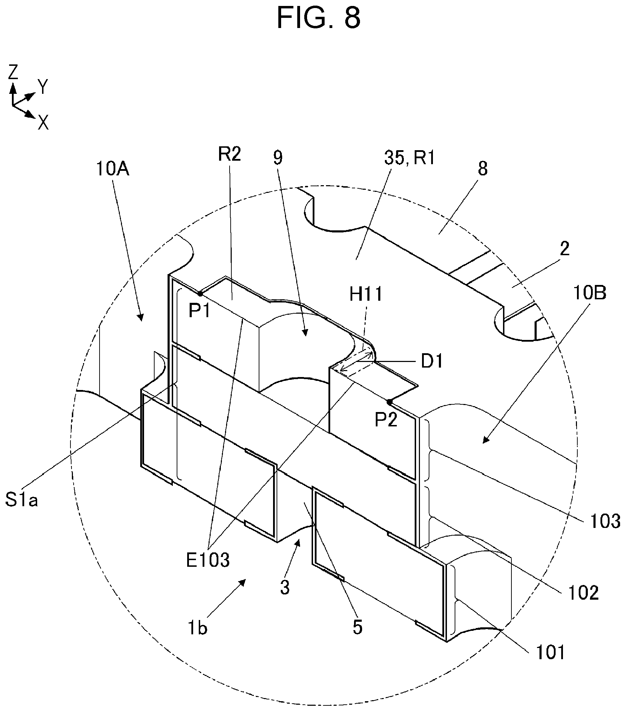

FIG. 8 is an enlarged perspective view illustrating the area around the first cutout portion.

The third top surface of the third substrate 103 includes a conductor region R1 where the metal layer 35 is positioned and a non-conductor region R2 where the metal layer 35 is not positioned. The non-conductor region R2 extends from a position P1 between the first recess 10A and the first cutout portion 9 to a position P2 between the first cutout portion 9 and the second recess 10B up to an outer edge E103 (FIG. 8) of the third top surface of the third substrate 103. The outer edge E103 of the third top surface means the edge of the third top surface of the third substrate 103 on the side where the first outer surface S1a is located. With this configuration, when forming the first outer surface S1a by performing dicing or the like, the generation of burrs in the metal layer 35 can be reduced at the outer edge E103 of the third top surface from the position P1 to the position P2. Therefore, the occurrence of a situation in which conductors such as burrs are located on the first outer surface S1a in the vicinity of where the signal line 2 is positioned is reduced, and stable frequency characteristics are obtained. Furthermore, adjustment of the characteristic impedance of the signal transmission part 1b is easily realized by adjusting the area of the non-conductor region R2.

The non-conductor region R2 includes a wider portion H11 (FIG. 8) whose width D1 in the Y direction (direction perpendicular to the first outer surface S1a) increases with increasing proximity to the first cutout portion 9. With this configuration, the impedance of a radio-frequency signal conducted from the signal line 2 to the side surface conductor 5 can be easily reduced.

The conductor region R1 extends across the entirety of an edge E10A (FIG. 4) of the first recess 10A located on the third top surface of the third substrate 103, as well as the entirety of an edge E10B (FIG. 4) of the second recess 10B located on the third top surface of the third substrate 103. This configuration stabilizes the ground potential of the metal layer 35.

(Variation 1)

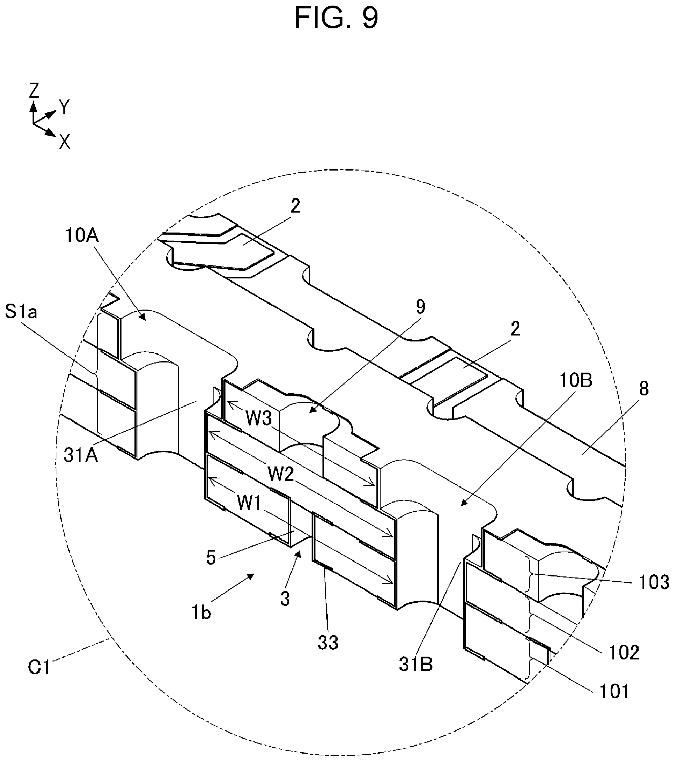

FIG. 9 is a diagram illustrating part of a semiconductor element mounting substrate of Variation 1. Part C1 illustrated in FIG. 9 corresponds to part C1 of FIG. 2A.

As illustrated in FIG. 9, the spacing W1 between the first recess 10A and the second recess 10B in the first substrate 101, the spacing W2 between the first recess 10A and the second recess 10B in the second substrate 102, and the spacing W3 between the first recess 10A and the second recess 10B in the third substrate 103 may be set to satisfy a condition (5).

$$W2 > W3...(5)$$

In addition, condition (6) may be satisfied.

$$W1 = W2...(6)$$

When condition (5) is satisfied, the spacing between the first side surface ground conductor 31A and the second side surface ground conductor 31B is smaller above the groove 3. Therefore, the cutoff frequency of a radio-frequency signal transmitted through the side surface conductor 5 inside the groove 3, the electrode 6, the through conductor 4, and the signal line 2 is increased, and the bandwidth of the frequency characteristics of the signal transmission part 1b is broadened. Furthermore, since the spacing between the groove 3 and the first recess 10A and the spacing between the groove 3 and the second recess 10B can be increased while achieving a wider bandwidth, the reliability of the semiconductor element mounting substrate 1 in terms of mounting can be improved.

By satisfying condition (6), the first recess 10A and second recess 10B located in the first substrate 101 and the first recess 10A and second recess 10B located in the second substrate 102 can overlap in plan view in a large number of regions. In the regions that overlap in plan view, the first side surface ground conductor 31A and the second side surface ground conductor 31B located on the first substrate 101 and the first side surface ground conductor 31A and the second side surface ground conductor 31B located on the second substrate 102 are continuous with each other. Therefore, the shapes of the first side surface ground conductor 31A and the second side surface ground conductor 31B can be stabilized and the ground potential of the signal transmission part 1b can be stabilized. Thus, the frequency characteristics of the signal transmission part 1b can be stabilized.

(Variation 2)

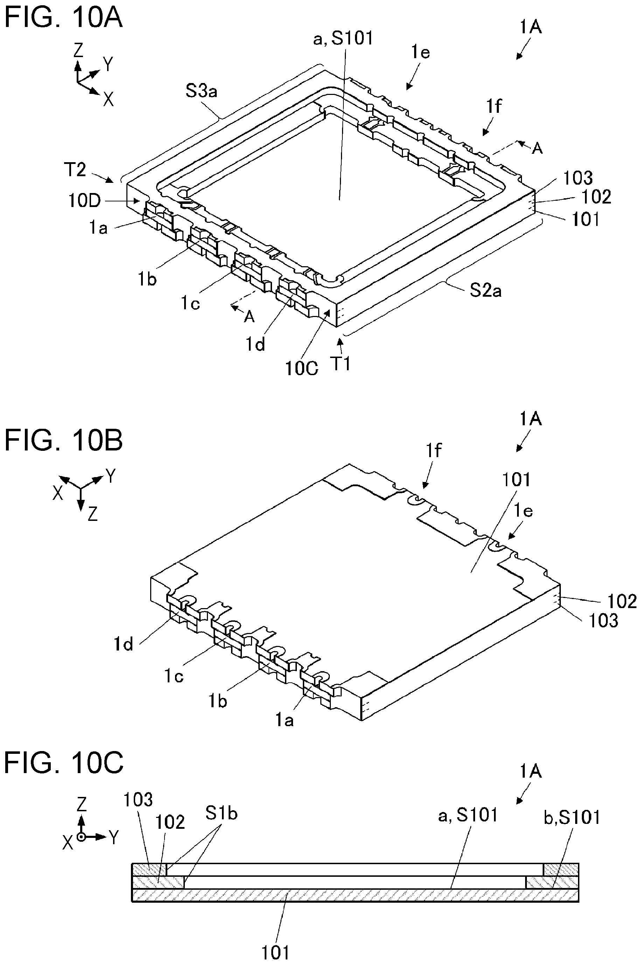

FIGs. 10A to 10C illustrate a semiconductor element mounting substrate according to Variation 2. FIG. 10A is a perspective view of a semiconductor element mounting substrate 1A according to Variation 2 viewed from above, FIG. 10B is a perspective view of the semiconductor element mounting substrate 1A viewed from below, and FIG. 10C is a sectional view taken along line A-A in FIG. 10A. As illustrated in FIGs. 10A to 10C, the first substrate 101 may have an integrated configuration including the mounting region a and the peripheral region b. The semiconductor element mounting substrate 1A having this configuration does not include the gap 30 of the first substrate 101 illustrated in FIG. 3, the first inner surface S1b of the first substrate 101, or the second cutout portion 41 illustrated in FIG. 5. The rest of the configuration is substantially the same as that of the semiconductor element mounting substrate 1 of the above-described embodiment.

In the semiconductor element mounting substrate 1A of Variation 2, the same or similar effects are achieved by the constituent parts common to the semiconductor element mounting substrate 1 described in Embodiment 1.

(Variation 3)

As illustrated in FIG. 2A or FIG. 10A, the first substrate 101, the second substrate 102, and the third substrate 103 have the first outer surface S1a and adjacent outer surfaces S2a and S3a, a corner T1 positioned between the first outer surface S1a and the outer surface S2a, and a corner T2 positioned between the first outer surface S1a and the outer surface S3a. A second recess 10C may intersect the outer surface S2a, as illustrated in the signal transmission part 1d in FIG. 2A or FIG. 10A. Similarly, a first recess 10D may intersect the outer surface S3a, as illustrated in the signal transmission part 1a in FIG. 2A or FIG. 10A. The outer surfaces S2a and S3a corresponding to examples of a second outer surface according to the present disclosure.

With this configuration, the shapes of the first substrate 101, the second substrate 102, and the third substrate 103 in the vicinity of the corners T1 and T2 are simplified, and the risk of damage such as cracks occurring in the corners T1 and T2 can be reduced.

(Configuration of Semiconductor Device)

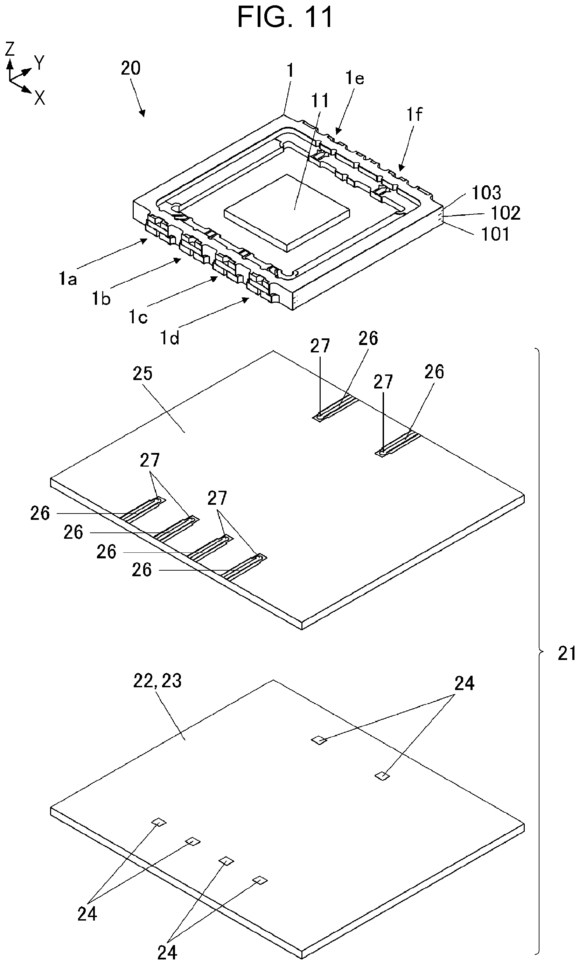

FIG. 11 is an exploded perspective view of the semiconductor device in FIG. 1. When assembling the semiconductor device 20, the semiconductor element 11 is placed on the mounting region a of the first substrate 101, the semiconductor element 11 is adhered and fixed to the first substrate 101 via an adhesive or the like, and the semiconductor element 11 and the signal line 2 are electrically connected to each other via bonding wires or the like. In this way, the semiconductor device 20 is completed as a product by mounting the semiconductor element 11 on the semiconductor element mounting substrate 1. Although not illustrated, a cover may be provided on the top surface of the semiconductor element mounting substrate 1.

The semiconductor device 20 may further include a mounting substrate 21 bonded to the first bottom surface of the first substrate 101. The mounting substrate 21 includes multiple insulating layers, for example. Signal conductors 26 and second connection terminals 27 composed of a metal material such as copper foil are provided on the top surface of the uppermost insulating layer. The signal conductors 26 and the second connection terminals 27 are electrically connected to the side surface conductors 5 and the signal electrodes 33 on the first bottom surface via a conductive bonding material such as solder, and radio-frequency electrical signals are transmitted therethrough. Furthermore, the mounting substrate 21 is provided with the ground layer 25 as the uppermost layer. The ground layer 25 is composed of a metal material, such as copper foil, arranged at predetermined intervals on the top surface of the uppermost layer so as to sandwich the signal conductors 26 and surround the second connection terminals 27, and is maintained at the ground potential.

The ground layer 25 is bonded to the metal layers 34 provided on the bottom surface of the semiconductor element mounting substrate 1, the first side surface ground conductors 31A, the second side surface ground conductors 31B, and the bottom surface of the mounting region a composed of a metal material via a bonding material such as solder. The mounting substrate 21 is provided with the above-described second connection terminals 27, signal conductors 26, and ground layer 25 on the top surface, and this allows so-called coplanar lines, which are one type of planar transmission lines, to be formed.

The mounting substrate 21 may include a ground conductor 22 formed on an inner layer thereof. The ground conductor 22 includes a formed region 23 where the ground conductor 22 is formed and non-formed regions 24 where the ground conductor 22 is not formed. The non-formed regions 24 of the ground conductor layer are not provided, in plan view, at least at positions overlapping the signal electrodes 33 (FIG. 6) on the first bottom surface and the second connection terminals 27. This configuration can reduce the difficulty of making adjustments to the desired characteristic impedance range when mounting the semiconductor device 20 on the mounting substrate 21. This is because if the non-formed regions 24 overlap the signal electrodes 33 (FIG. 6) and the second connection terminals 27, the capacitances generated with the ground potential parts in the signal transmission portions between the signal conductors 26 and the side surface conductors 5 are increased by the conductive bonding material, such as solder, electrically connecting the signal electrodes 33 on the first bottom surface to the second connection terminals 27, and the meniscus formed on the side surfaces of the side surface conductors 5 by this bonding material, and the characteristic impedance is reduced.

Each non-formed region 24 may be positioned, in plan view, inward from (on the side surface conductor 5 side) the first side surface ground conductor 31A and the second side surface ground conductor 31B between which the side surface conductor 5 is interposed in a direction perpendicular to the signal transmission direction of the signal line 2 (i.e., direction from the signal line 2 to the semiconductor element 11). With this configuration, unnecessary and unstable spreading of the electric field distribution and fluctuations in the characteristic impedance in the signal transmission portions between the signal conductor 26 and the side surface conductor 5 can be reduced. As a result, the frequency characteristics in the signal transmission portions of the semiconductor element mounting substrate 1 can be further improved.

The present disclosure is not limited to the embodiments described above, and can be modified in various ways without departing from the gist of the present disclosure. The spacings W1, W2, and W3, as well as the widths W21, W22, W23, W25a, and W25b, described above, do not need to be constant from the top to the bottom of the corresponding region. If the value differs depending on the height of the measurement, a representative value may be obtained from values measured at multiple heights obtained by equally dividing the corresponding region from top to bottom, and the representative value may be used as the value for the spacings W1, W2, and W3, and the widths W21, W22, W23, W25a, and W25b. The central 80% of measured values may be extracted from measured values at the multiple heights, and the average of the extracted measured values may be adopted as the representative value.

INDUSTRIAL APPLICABILITY

The present disclosure can be used in a semiconductor element mounting substrate and a semiconductor device.

REFERENCE SIGNS

| | |
|---|---|
| 1 | semiconductor element mounting substrate |
| 1e to 1f | signal transmission part |
| 101 | first substrate |
| 102 | second substrate |
| 103 | third substrate |
| a | mounting region |
| b | peripheral region |
| 2 | signal line |
| 3 | groove |
| 4 | through conductor |
| 5 | side surface conductor |
| 6 | electrode |
| 7 | first ground conductor layer |
| 8 | second ground conductor layer |
| 9 | first cutout portion |
| 10A, 10D | first recess |
| 10B, 10C | second recess |
| 11 | semiconductor element |
| 20 | semiconductor device |
| 21 | mounting substrate |
| 22 | ground conductor |
| 23 | formed region |
| 24 | non-formed region |
| 25 | ground layer |
| 26 | signal conductor |
| 27 | second connection terminal |
| 28 | connection terminal |
| 30 | gap |
| 31A | first side surface ground conductor |
| 31B | second side surface ground conductor |
| 32 | inner surface groove |
| 33 | signal electrode |
| 34 | metal layer |
| 35 | metal layer |
| 41 | second cutout portion |
| S101 | first top surface |
| S1a | first outer surface |
| S1b | first inner surface |
| S2a, S3a | outer surface (second outer surface) |
| T1, T2 | corner |
| H1 | width reduction portion |

| H11 | wider portion |
|---|---|
| W1 to W3 | spacing |
| W21 to W23, W25a, W25b, D1 | width |
| R1 | conductor region |
| R2 | non-conductor region |

**Claims**

1. A semiconductor element mounting substrate comprising:

   a first substrate having a first top surface including a mounting region allowing mounting of a semiconductor element and a peripheral region surrounding the mounting region;
   a frame-shaped second substrate positioned on the peripheral region of the first substrate and surrounding the mounting region; and
   a frame-shaped third substrate positioned on the second substrate and surrounding the mounting region,
   the first substrate, the second substrate, and the third substrate having a common outward facing first outer surface,
   the semiconductor element mounting substrate further comprising:

   a groove positioned extending from a first top surface to a first bottom surface of the first substrate on the first outer surface;
   a signal line positioned on a second top surface of the second substrate;
   a through conductor positioned inside the second substrate and connected to the signal line;
   a side surface conductor positioned on an inner surface of the groove and electrically connected to the through conductor;
   a first cutout portion positioned on the first outer surface of the third substrate and overlapping the groove in planar perspective view;
   a first recess and a second recess positioned extending from a third top surface of the third substrate to the first bottom surface of the first substrate and positioned side by side with the groove interposed therebetween; and
   a first side surface ground conductor and a second side surface ground conductor respectively positioned on an inner surface of the first recess and an inner surface of the second recess,
   wherein a width reduction portion is provided between the first recess and the second recess, a spacing between the first recess and the second recess being smaller at a top of the width reduction portion than at a bottom of the width reduction portion.

2. The semiconductor element mounting substrate according to claim 1,

   wherein a spacing W1 between the first recess and the second recess in the first substrate, a spacing W2 between the first recess and the second recess in the second substrate, and a spacing W3 between the first recess and the second recess in the third substrate satisfy

   $$W1 \geq W2, W2 \geq W3,$$

   and
   at least one of values of W1, W2, and W3 is different.

3. The semiconductor element mounting substrate according to claim 2,
   wherein W1 > W2.

4. The semiconductor element mounting substrate according to claim 3,
   wherein W2 = W3.

5. The semiconductor element mounting substrate according to any one of claims 1 to 4,

   wherein the first substrate has a first inner surface on an opposite side from the first outer surface,

the semiconductor element mounting substrate further comprising:

    a signal electrode extending on the first bottom surface of the first substrate and connected to the side surface conductor, and
    a second cutout portion positioned on the first inner surface.

6. The semiconductor element mounting substrate according to claim 5,
wherein the second cutout portion overlaps the groove when viewed in perspective view in a direction perpendicular to the first outer surface.

7. The semiconductor element mounting substrate according to claim 5 or 6,
wherein a width of the first cutout portion in a first direction along an outer edge of the third top surface of the third substrate is greater than a width of the groove in the first direction.

8. The semiconductor element mounting substrate according to any one of claims 5 to 7,
wherein a width of the second cutout portion in a first direction along an outer edge of the third top surface of the third substrate is greater than a width of the first cutout portion in the first direction.

9. The semiconductor element mounting substrate according to any one of claims 1 to 7,
wherein a width of the first cutout portion in a first direction along an outer edge of the third top surface of the third substrate is smaller than a width of the first recess located in the third substrate in the first direction or a width of the second recess located in the third substrate in the first direction.

10. The semiconductor element mounting substrate according to any one of claims 1 to 9,

    wherein the third top surface of the third substrate includes a conductor region where a metal layer is positioned and a non-conductor region where the metal layer is not positioned, and
    the non-conductor region extends from between the first recess and the first cutout portion to an outer edge of the third top surface of the third substrate between the first recess and the second recess.

11. The semiconductor element mounting substrate according to claim 10,
wherein the non-conductor region includes a wider portion whose width in a direction perpendicular to the first outer surface increases with increasing proximity to the first cutout portion.

12. The semiconductor element mounting substrate according to claim 10 or 11,
wherein the conductor region extends over an entire area of an edge of the first recess located at the third top surface of the third substrate and an entire area of an edge of the second recess located at the third top surface of the third substrate.

13. The semiconductor element mounting substrate according to any one of claims 1 to 12,

    wherein the first substrate, the second substrate, and the third substrate have a second outer surface adjacent to the first outer surface, and
    the first recess or the second recess intersects the second outer surface.

14. A semiconductor device comprising:

    the semiconductor element mounting substrate according to any one of claims 1 to 13, and
    a semiconductor element mounted on the mounting region and electrically connected to the signal line.

15. The semiconductor device according to claim 14, further comprising:
a mounting substrate bonded to the first bottom surface of the first substrate.

# FIG. 1

FIG. 2A

FIG. 2B

FIG. 2C

# FIG. 3

# FIG. 4

# FIG. 5

# FIG. 6

# FIG. 7

# FIG. 8

# FIG. 9

# FIG. 10A

# FIG. 10B

# FIG. 10C

# FIG. 11

## INTERNATIONAL SEARCH REPORT

| International application No. |
|---|
| **PCT/JP2022/036055** |

**A. CLASSIFICATION OF SUBJECT MATTER**

*H01L 23/12*(2006.01)i; *H05K 1/14*(2006.01)i
FI:  H01L23/12 N; H01L23/12 Q; H01L23/12 E; H05K1/14 G

According to International Patent Classification (IPC) or to both national classification and IPC

**B. FIELDS SEARCHED**

Minimum documentation searched (classification system followed by classification symbols)

H01L23/12; H05K1/14

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2020-120076 A (KYOCERA CORP) 06 August 2020 (2020-08-06) entire text, all drawings | 1-15 |
| A | WO 2018/021209 A1 (KYOCERA CORP) 01 February 2018 (2018-02-01) entire text, all drawings | 1-15 |
| A | JP 2003-243556 A (MURATA MFG CO LTD) 29 August 2003 (2003-08-29) entire text, all drawings | 1-15 |
| A | JP 2014-146759 A (KYOCERA CORP) 14 August 2014 (2014-08-14) entire text, all drawings | 1-15 |

☐ Further documents are listed in the continuation of Box C.    ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **05 December 2022** | **13 December 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/036055**

| Patent document cited in search report | | | Publication date (day/month/year) | Patent family member(s) | | | Publication date (day/month/year) |
|---|---|---|---|---|---|---|---|
| JP | 2020-120076 | A | 06 August 2020 | (Family: none) | | | |
| WO | 2018/021209 | A1 | 01 February 2018 | US | 2019/0221507 | A1 | |
| | | | | entire text, all drawings | | | |
| | | | | EP | 3493252 | A1 | |
| | | | | CN | 109478537 | A | |
| | | | | JP | 2021-101475 | A | |
| JP | 2003-243556 | A | 29 August 2003 | (Family: none) | | | |
| JP | 2014-146759 | A | 14 August 2014 | (Family: none) | | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018021209 A